# EUROPEAN PATENT APPLICATION

(11) **EP 3 413 061 A1**
(43) Date of publication of application: **12.12.2018**
(21) Application number: 17175013.6
(22) Date of filing: 08.06.2017
(51) Int. Cl.: G01R 1/073, G01R 31/28, G01R 1/04

(54) **CONTACTOR SOCKET AND IC TEST HANDLER**

(71) Applicant: Rasco GmbH, 83059 Kolbermoor (DE)
(72) Inventor: Pötzinger, Johann, 83730 Fischbachau (DE)
(74) Representative: Heinze, Ekkehard

(57) **Abstract**

Contactor socket of an IC test handler, the contactor socket comprising a contactor socket body (50) having a first (51a) and second (52a) plane surface, the second plane surface being parallel and opposite to the first plane surface, and a line or an array of test contacts (54) supported within the contactor socket body, extending normal to the and between the first and second plane surface and adapted for providing elastic pressure contact with IC device contacts of a plurality of ICs which are positioned on the first plane surface and/or with test device contacts of a test device positioned on the second plane surface and, thus, an electrical connection between the IC device contacts and test device contacts, wherein the first (51) and/or second body portion (52) comprises a line or an array of individual spring-loaded supports for holding each of the test contacts of the line or array in elastic pre-tension towards the first and second plane surface, wherein the contactor socket body comprises a first and second body portion, the first body portion defining the first plane surface and the second body portion defining the second plane surface, the first and second body portions being connected to each other such that they are movable relative to each other in a direction normal to the first and second plane surfaces, and socket body pre-biasing means (53) for biasing the first body portion against the second body portion normal to the first and second plane surfaces and, herewith, to provide additional spring stroke to the stroke provided by the individual spring-loaded test contact supports are provided.

## Description

### Field of the Invention

The invention is related to a contactor socket of an IC test handler, which has test contacts for contacting an IC or a group of ICs in test and is adapted for temporarily pressing the IC or ICs against the test contacts. It further relates to an IC test handler.

### Prior Art

It is well-known to run test procedures on integrated circuits, e.g. in a configuration where the ICs are arranged on an IC strip, to verify the correct function of the ICs. Such test systems allow for a simultaneous testing of a plurality of ICs, which increases the throughput of the testing system and, therefore, the productivity and results in a cost reduction per IC. A dedicated test-in-strip handler places the ICs in contact with a contactor socket of the test system, maintains the contact for the duration of the test cycle, and finally sorts the ICs depending on the test results, before delivering them to a packaging stage or other stages for further processing.

In a test-in-strip handler, a loader unit is provided which contains a stack of IC strips. From this stack, individual IC strips are fed to a testing unit which comprises a plunger or plunger head, for example, that positions the selected IC strip such that the test contacts of the contactor socket come into electrical contact with respective device contacts of the ICs. Thereafter, the above-referenced test procedure is started and implemented. After testing, the IC strip is unloaded to an unloader unit, and the above-mentioned sorting operation is carried out.

A contactor arrangement according to the state of the art is disclosed in EP 2963430 A1 of the applicant.

### Description of the Invention

It is an object of the invention to provide an improved contactor socket, which in particular can be built with smaller and simpler and, therefore, cheaper test contacts and can offer more flexibility in its electrical and mechanical functions and usability.

This object is solved by a contactor socket comprising the features of claim 1. According to a further aspect of the invention, the object is solved by an IC test handler of claim 14. Embodiments of the invention are subject of the dependent claims.

It is an aspect of the invention, that the contactor circuit body is split into a first and second body portion, the first body portion defining the first plane surface and the second body portion defining the second plane surface, the first and second body portions being connected to each other such that they are movable relative to each other in a direction normal to the first and second plane surfaces. Herein, the first and/or second body portion comprise individual spring-loaded supports for holding each of the test contacts of the line or array in elastic pre-tension towards the first and/or second plane surface. It is important that all test contacts of the line or array are supported in at least one of the two body portions and pre-biased therein normal to at least one outer surface (first or second plane surface) of the socket body. According to a third aspect of the invention, socket body pre-biasing means for biasing the first body portion against the second body portion normal to the first and second plane surfaces and, herewith, to provide additional spring stroke to the stroke provided by the individual spring-loaded test contact supports are provided.

In this way, the overall stroke of the elastic pressing of the socket contacts against the IC device contacts and/or the test device contacts is sub-divided into two stroke portions: A first one provided by the spring-loaded supports of the individual socket contacts, and the other one provided by the pre-biasing means arranged between the first and second socket body portions. This makes it possible to use socket contacts or test contacts, respectively, and corresponding supports, which are smaller and simpler in their construction and can, therefore, be cheaper.

Furthermore, notwithstanding the required two-part configuration of the socket body, the invention offers the option to make the contactor socket more compact, in particular to reduce the thickness and total length thereof. Still further, the invention offers the option to predetermine or adjust the contact pressure provided by the contactor socket in a more flexible way. Last but not least, the two-part construction of the socket body offers more flexibility with regard to cooling or temperature control requirements related to only one of the first and second plane surfaces of the contactor socket.

According to an embodiment of the invention, the first and second body portions are each plate-shaped and have main surfaces which are all parallel to each other, wherein the outermost main surfaces are the first and second plane surface. Such embodiment is easy to manufacture and can be made from commercially available semi-finished parts.

In a further embodiment, the socket body pre-biasing means are adapted for movably connecting the first and second body portions to each other and guiding them for a relative motion normal to the first and second plane surfaces. In other words, the connecting/guiding and pre-biasing functions are basically provided by the biasing means themselves. In an implementation of this embodiment, the biasing means comprise an elastomer sheet which is fixedly arranged, in particular glued, between the adjacent main surfaces of the first and second body portions.

In other embodiments, the socket body pre-biasing means comprise separate elastic members which are e.g. loosely inserted between the first and second body portions, and separate connecting and guiding means for connecting the first and second body portions and for guiding them for a motion normal to the first and second plane surfaces are provided. At present, such embodiments appear to be particularly suitable to provide a highest level of accuracy and durability of the inventive contactor socket.

In further embodiments, the socket body pre-biasing means comprise at least one pressure spring element arranged between the first and second body portions. More specifically, the socket body pre-biasing means comprise at least two, in particular at least four, pressure spring elements arranged close to the short edges or the corners, respectively, of the first and second plane surfaces of the contactor socket body. Herein, the or each pressure spring element comprises a helical metal spring, in particular made of a copper-beryllium alloy or of steel. Further materials which are typically used in the technical field for manufacturing precise and reliable elastic members, can likewise be used.

In further embodiments, the pressure spring elements of the socket body pre-biasing means each have a stroke in the range between 0,1 and 1mm, preferably between 0,3 and 0,7mm, and/or a spring rate in the range between 1N and 10N. In particular, these values hold for contactor socket configurations which comprise test contacts which have helical metal springs and/or cantilever springs which have a stroke in the range between 0,02mm and 0,5mm, preferably between 0,03mm and 0,2mm, and/or a spring rate in the range between 0,02N and 0,2N, preferably between 0,05N and 0,10N. For other test contact configurations and for a very low or very large number of test contacts in the contactor socket, different values for the stroke and spring rate of the pressure spring elements of the socket body pre-biasing means may be preferred.

In further embodiments, the socket body pre-biasing means comprise a pneumatic or hydraulic actuator, wherein in particular the biasing force of the pneumatic or hydraulic actuator is adjustable. Although such embodiments would inevitably be more complicated than biasing means of the elastomer or metal spring type, they might offer certain advantages for specific applications, e.g. regarding the controllability of the elastic pressure provided by the contactor socket.

In further embodiments, the test contacts are probe pins and wherein the individual spring-loaded supports each comprise helical metal springs. Socket contacts of this type are well-known as "Pogo pins", but other pin-type test contacts and corresponding supports can be used as well.

In alternative embodiments, the test contacts are cantilever spring contacts and the individual spring-loaded supports thereof each comprise a cantilever spring. Such cantilever spring contacts are likewise known in the field and are being used in state-of-the-art contactor units.

In further embodiments, the contactor socket may comprise a gas inlet for introducing pressurized gas between the first and second body portions, and/or temperature control means adapted for controlling the temperature of at least one of the first and second body portions. By means of pressurized gas, the gap between the first and second body portions can be re-configured to achieve a planar configuration, to compensate for some buckling or warping which can result from the pressure exerted by the array of spring-loaded test contacts in the central portion of the contactor socket. The temperature control means could be used to reduce or stabilize a desired temperature of only one of the first and second main surfaces of the contactor socket, without essentially influencing the temperature of the respective other surface.

Such configuration offers options for adjusting or stabilizing an ideal flatness of the first and/or second plane surface of the contactor socket, notwithstanding the inventive split of the socket body into two separate parts, and of cooling and/or heating the relevant surfaces independently. Correspondingly, a test handler would comprise a pressurized gas supply for supplying pressurized gas to the contactor socket, and/or a temperature control unit for variably controlling the temperature of at least one of the first and second body portions of the contactor socket.

In a practically important embodiment, a contactor socket interface is adapted to fit to a contactor socket comprising a matrix-like arrangement of spring-loaded test contacts, e.g. pogo pins, such that, in test, the test contacts penetrate the strip contact surface of the contactor socket interface and touch the device contacts of the ICs. Preferably, the contactor socket interface has a thin central portion comprising a matrix of through-holes which corresponds to the test contact matrix of the contactor socket. This central portion is surrounded by an interface frame, whereby inner edges of the interface frame correspond to outer edges of the contactor socket such that an outer circumference of the contactor socket is enclosed in the interface frame.

In further embodiments, the contactor socket interface is movable with respect to the contactor socket along an axis which is normal to the strip contact surface, in particular against a pre-loading force of spring means or hydraulic or pneumatic pre-loading means which pre-loads the IC or an IC strip, respectively, away from the test contacts, and is driven by the plunger head towards the test contacts.

In a further embodiment of the invention, the IC test handler is embodied as a test-in-strip handler, wherein the plunger head, the contactor socket, and the contactor socket interface are each adapted to receive and handle an IC strip containing a plurality of ICs, and wherein the contactor socket is adapted for simultaneously contacting the plurality of ICs on the strip. However, the invention can likewise be embodied in other types of IC test handlers, e.g. in pick-and-place handlers or gravity handlers, with correspondingly adapted plunger head, contactor socket and contactor socket interface configurations. The invention can be applied on groups of ICs, which are handled and tested simultaneously but which are not arranged on a strip but on some other carrier or tray etc. The above-mentioned recess in the plunger head or some other IC transport means, as well as the means for attracting the ICs to the test contacts will be adapted to the respective carrier or tray etc.

An improved overall test arrangement comprises, besides an IC test handler as mentioned above, a testing device which comprises a contactor socket, an IC parameter measuring and evaluating unit and a test procedure control unit.

### Brief Description of the Drawings

Further embodiments and advantages of the invention or of specific elements or aspects thereof are explained in the following description, and related to the appending drawings. In the drawings,
Fig. 1 shows major parts of a contactor arrangement according to an embodiment of the invention, in a sectional view;
Fig. 2 shows a contactor socket and contactor socket interface, according to the embodiment of Fig. 1, together with a portion of a test device, in a perspective sectional view;
Fig. 3 shows an embodiment of the contactor socket and contactor socket interface in a perspective view taken from the IC strip side;
Fig. 4 shows an embodiment of the contactor socket and contactor socket interface, together with the plunger head, in a perspective view taken from the test device side;
Fig. 5 shows a sectional detail view of a contactor socket according to an embodiment of the invention;
Fig. 6 shows a sectional detail view of a contactor socket according to a further embodiment of the invention;
Fig. 7 shows a perspective cross-sectional view of a modified configuration of the contactor socket of Fig. 5; and
Fig. 8 shows a perspective cross-sectional view of a modified configuration of the contactor socket of Fig. 6.

### Description of the Embodiments

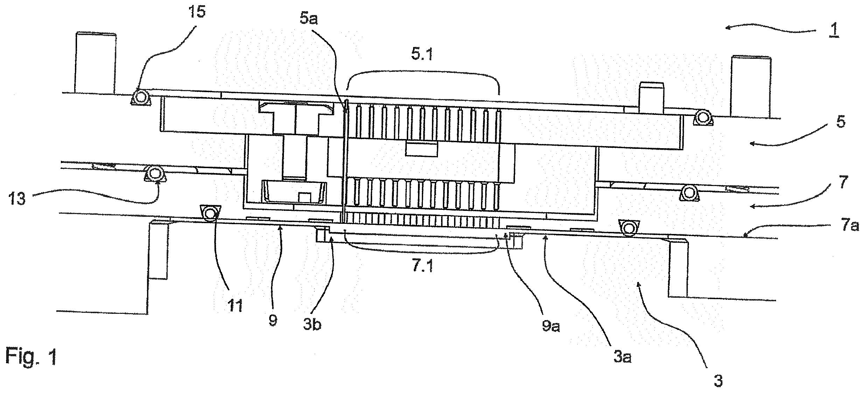

Fig. 1 schematically shows, in a sectional view, major components of a contactor arrangement, exemplified in a test-in-strip handler 1, namely the upper portion of a plunger head 3, a contactor socket 5 and a frame-shaped contactor socket interface 7, together with an IC strip 9 inserted between the upper surface 3a of the plunger head 3 and the lower surface (strip contacting surface) 7a of the contactor socket interface 7.

In the upper central portion of the plunger head 3, a recess 3b is provided, the position and dimensions of which correspond to the position and dimensions of an IC group which is arranged on the IC strip 9. The recess 3b serves for making sure that the lower surfaces of ICs 9a arranged on the IC strip 9 do not come into mechanical contact with the plunger head surface. This is particularly important in case that the ICs are of the bare-die type, i.e., a type for which any mechanical contact to the surface opposed to their contact surface should be avoided. The contactor socket 5 comprises a matrix-shaped arrangement 5.1 of a plurality of spring-loaded pogo pins 5a serving as test contacts.

The contactor socket interface 7 comprises a corresponding arrangement 7.1 of through holes to be penetrated by the pogo pins 5a of the contactor socket 5 in operation of the handler arrangement (in the following, simply mentioned as "in-test").

First, second, and third sealing elements (rope seals) 11, 13, 15 are provided between the upper surface 3a of the plunger head 3 and the strip contacting surface 7a of the contactor socket interface, between the upper surface of the contactor socket interface 7 and the lower surface of the contactor socket 5 and on the upper surface of the contactor socket 5, respectively. The latter seal 15 serves for sealing the upper surface of the contactor socket 5 against an adjacent surface of an interface, e.g. a PCB board (not shown) of a test device. The functions of the seals 11, 13, 15 are explained further below.

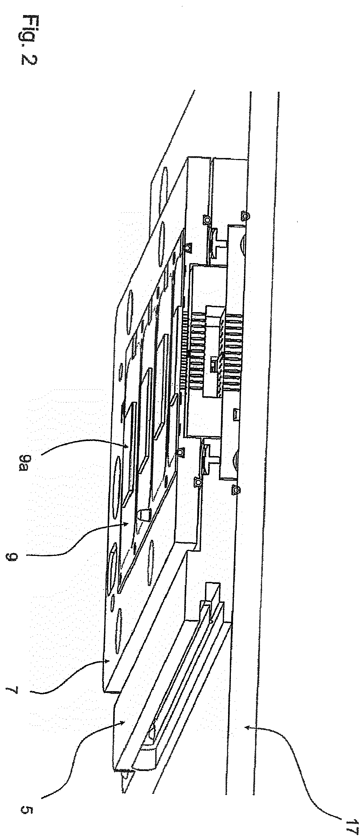

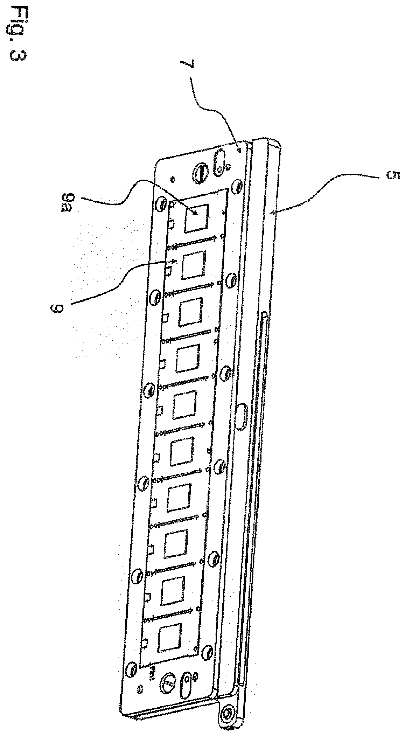

Fig. 2 shows, in a perspective sectional view, the contactor socket 5 together with the contactor socket interface 7 and the IC strip 9. Above the contactor socket 5, a PCB board 17 of a test device is shown schematically. In this figure, several ICs 9a arranged on the IC strip 9 can be recognised. Whereas Fig. 2 shows only a part of the contactor socket 5, contactor socket interface 7 and IC strip 9, all these are shown in their full extension in Fig. 3.

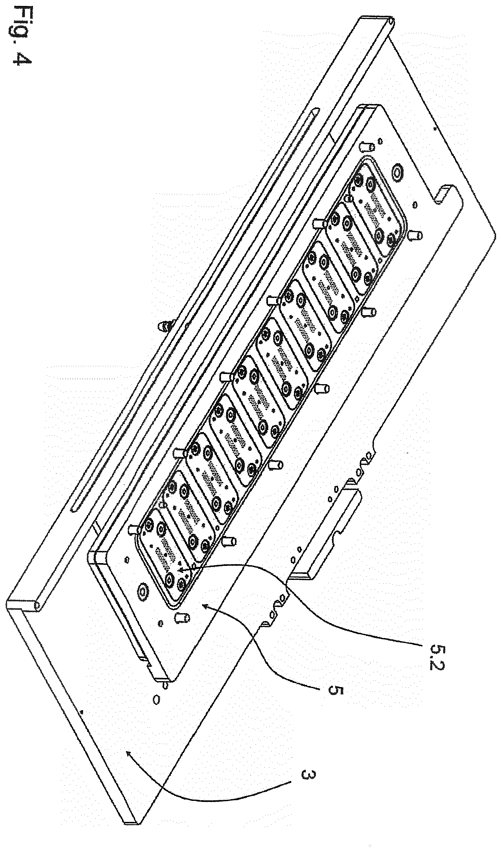

Fig. 4 shows the contactor socket 5, together with the plunger head 3, in a perspective view taken from above, i.e., from a point of view where, in operation of a test-in-strip test arrangement, the test device would be provided. In this view, it can be recognised that, in the contactor socket 5, a plurality of IC contacting and supporting portions 5.2 is provided, which in this exemplary embodiment corresponds to the number of ICs arranged on an IC strip to be tested.

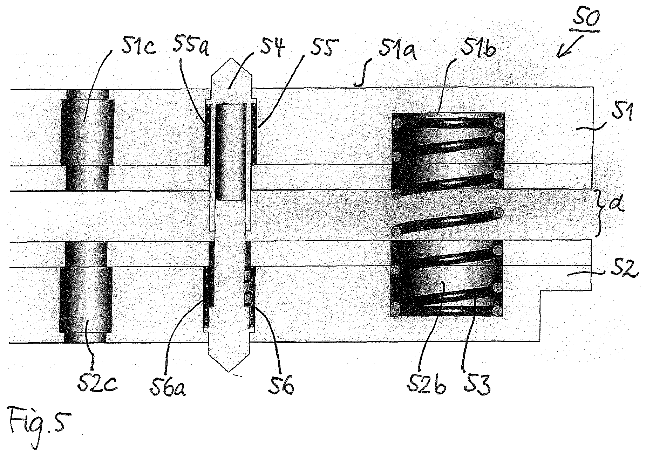

In Fig. 5, the contactor socket is designated with numeral 50 and is schematically illustrated as a partial view showing aspects of the invention in some detail. The contactor socket 50 has a socket body which is constituted by a first body portion 51 and a second body portion 52, both of which are basically plate-shaped. Other shapes like ledges are possible. The outer surface (upper surface) 51a of the first body portion 51 constitutes a first plane surface of the contactor socket, which in use is adjacent to an array of ICs (not shown) to be tested. The outer surface (lower surface) 52a of the second body portion 52 constitutes a second plane surface of the contactor socket, which in use is adjacent to device contacts of a test device (not shown) of a test arrangement.

Bores 51b in the inner surface (lower surface) of the first body portion 51 and 52b in the inner surface (upper surface) of the second body portion 52, which are arranged in opposition to each other, contain and guide a helical metal spring 53 serving as pre-biasing means for pre-biasing the first and second body portions 51, 52 away from each other. The helical spring 53 is dimensioned to maintain, in its relaxed state and preferably in cooperation with one or more further identical springs, a gap d between the first and second body portions 51, 52. This gap or distance d defines, in use of the contactor socket 50, a maximum effective stroke of the pre-biasing means, when providing pressure contact between IC device contacts of ICs to be tested and test device contacts of a test device.

Both first and second body portions 51, 52 contain an array of stepped through-holes 51c, 52c for supporting probe pins (test contacts or socket contacts, respectively) 54. The probe pins 54 can be of the Pogo-pin type, as shown in the figure, and are in both body portions 51, 52 supported in individual spring-loaded supports 55 and 56, respectively. The spring-loaded supports 55, 56 provide an individual pre-bias of each of the probe pins normally to both the first and second plane surfaces 51a, 52a of the contactor socket 50 and, herewith, against device contacts which are arranged adjacent to the respective surfaces.

The supports 55, 56 each contain small helical springs 55a, 56a. The strokes of the small helical springs 55a, 56a sum up to an individual stroke of each of the probe pins 54, which adds to the above-referenced stroke d of the larger helical spring 53, to arrive at a required total stroke of the contactor socket 50. The construction of the probe pins 54 and corresponding supports 55, 56 is, as such, known in the art as "pogo pins" and will, therefore, not be described here in detail.

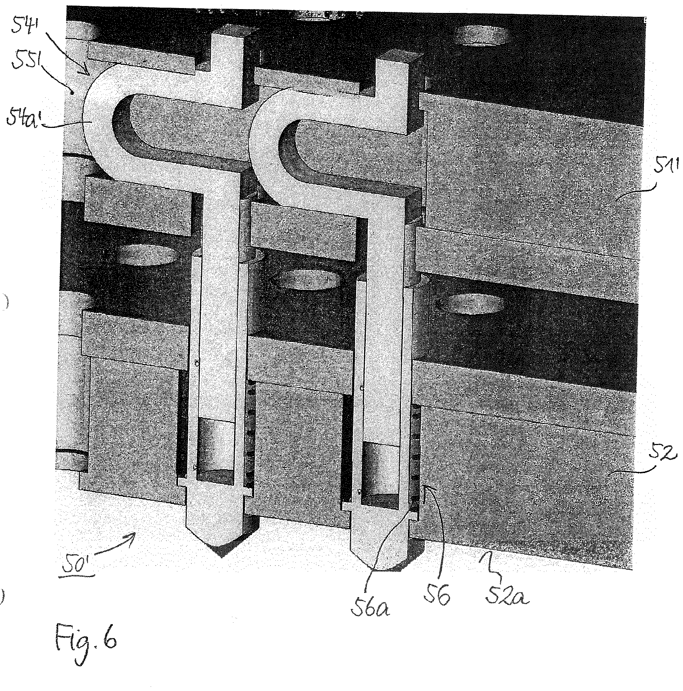

Fig. 6 shows a detail of another contactor socket 50', which is configured similar to the contactor socket 50 in Fig. 5. In so far, the components thereof are designated with reference numerals corresponding to Fig. 5, and not all explanations as to the basic structure of the contactor socket will be repeated here. This holds, in particular, for the structure of the second body portion 52, including the supports 56 arranged therein, and the helical springs 56a which are held in the supports 56.

Different from the contactor socket 50 of Fig. 5, in the contactor socket 50' cantilever test contacts 54' are provided, and the supports 55' in the first body portion 51' of the contactor socket each are adapted to the cantilever portion 54a' of the cantilever test contacts 54'. Whereas the lower portion of the test contacts 54', sitting in the second body portion 52, basically corresponds to the lower portion of the 'pogo pin' contacts of Fig. 5, the cantilever portion 54a' in the upper part of the test contacts 54' provides for an inherent resilience and corresponding elastic force generated by the test contacts themselves, without an additional spring element in the supports 55' within the first body portion 51'. In so far as in the above explanations and the claims a spring-loaded support for the test contacts is mentioned, it is to be understood that the 'spring load' of the support can be produced by an inherent elasticity of the test contacts.

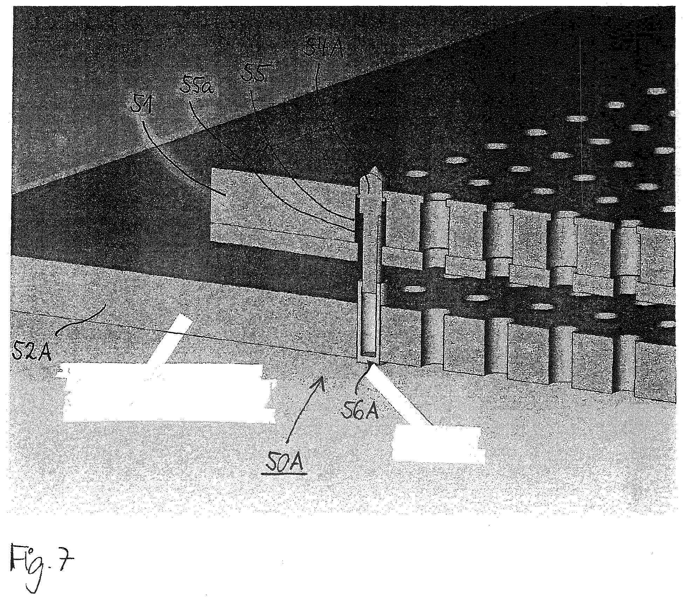

Fig. 7 schematically shows, as a further embodiment of the invention, another modification of the configuration shown in Fig. 5. This contactor socket 50a has the same split body, i.e. comprises a first body portion 51 and a second body portion 52a, both plate-shaped and in parallel and spaced-apart arrangement with respect to each other. Whereas the first body portion 51 essentially corresponds to the first body portion in Fig. 5, in the second body portion 52a the supports 56A are different from the supports 56 in Fig. 5.

Namely, the supports 56A are simple cylindrical bushings, press-fitted or soldered into the second body portion, e.g. printed circuit board, and receiving the lower cylindrical portion of modified probe pins 54A. The upper portion of the probe pins 54A has a shape which is identical to the 'pogo pins' in Fig. 5. As becomes clear from Fig. 7, this test contact configuration has only one spring-loaded support, i.e. the support 55 with the helical spring 55a in the first body portion 51.

It goes without saying, but is not shown in Fig. 7, the contactor socket 50A comprises the same or similar configuration of helical matter springs serving as socket body pre-biasing means between the first and second body portions.

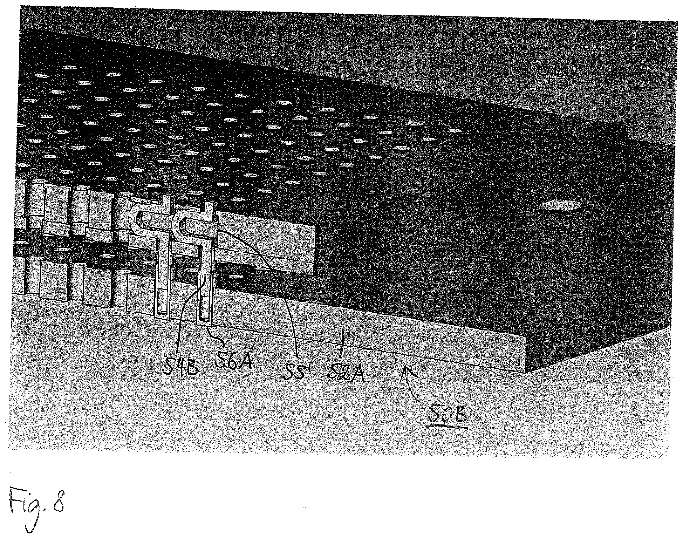

Fig. 8 shows, as a further embodiment of the invention, a configuration which is basically identical to that of Fig. 7 but which comprises cantilever test contacts 54B which are supported in recesses (supports) 55' in the first body portion 51' and in cylindrical bushings 56A (as in the arrangement of Fig. 7) in the second body portion 52A.

As in Fig. 7, in the arrangement of Fig. 8 socket body pre-biasing means are provided between the first and second body portions, but not shown in the figure.

The function of the handler arrangement according to Figures 1 - 8 and the above-referenced structures is as follows:
An IC strip 9 with a plurality of bare-die ICs 9a thereon is arranged on the plunger head 3 such that the peripheral portions of the IC strip 9 lie on the flat or plane outer portion of the plunger head surface 3a and are supported by the plunger head 3 and can be moved and fed to a test position by correspondingly controlled motions of the plunger head 3, as usual. However, due to the provision of the recess 3b in the central portion of the plunger head 3, the lower surfaces of the ICs 9a do not contact the plunger head.

After having arrived at an appropriate xy position to be contacted by the contactor socket 5, the respective IC strip 9 is pressed against or attracted towards the strip contact surface or lower surface of the contactor socket interface 7, e.g. by means of a plunger or by actuating a vacuum suction system within the contactor socket 5 and contactor socket interface 7. Due to pressure exerted by the plunger or the attractive force generated by the vacuum suction system, the IC strip 9 and, in particular, the ICs 9a are elevated by a z axis increment d, and their device contacts are brought into contact with the tips of the spring-loaded pogo pins 5a of the test contact arrangement 5.1 of the contactor socket 5. In this state, the upper surfaces of the ICs 9a are fully flush with the strip contact surface 7a, although the IC strip 9 is not supported by the plunger head 3 in these regions.

The z axis increment d is determined such that the overall contact pressure of the pogo pins against the corresponding device contacts of the ICs 9a is sufficient for all test requirements. The attractive force generated by a vacuum suction system is pre-determined such that even the force which is exerted on the ICs by the pogo pins 5a does not result in any warpage or deflection, for instance, of the central portion of the IC strip 9 away from the strip contact surface 7a of the contactor socket interface 7. Hence, even in test the ICs 9a are arranged ideally flush with the strip contact surface.

After the test program is terminated, the plunger is withdrawn or the vacuum suction system deactivated, respectively, and the IC strip 9 falls down to the plunger head, such that the IC strip 9 is now, again, exclusively held by the plunger head and without mechanical contact with the tips of the pogo pins 5a and the contactor socket interface. In this state, the IC strip and the ICs can be fed to other processing sites, e.g., to be sorted or handled according to a pre-determined handling scheme.

The embodiments and aspects of the invention explained above are not determined to limit the scope of the invention, which is exclusively to be determined by the attached claims. Many modifications of the inventive concept are possible within the scope of the claims and, more specifically, arbitrary combinations of the several claim features are considered to be within the scope of the invention.

## Claims

1. Contactor socket of an IC test handler, the contactor socket comprising a contactor socket body having a first and second plane surface, the second plane surface being parallel and opposite to the first plane surface, and a line or an array of test contacts supported within the contactor socket body, extending normal to the and between the first and second plane surface and adapted for providing elastic pressure contact with IC device contacts of a plurality of ICs which are positioned on the first plane surface and/or with test device contacts of a test device positioned on the second plane surface and, thus, an electrical connection between the IC device contacts and test device contacts, wherein the first and/or second body portion comprises a line or an array of individual spring-loaded supports for holding each of the test contacts of the line or array in elastic pre-tension towards the first and second plane surface,
**characterized in that**
the contactor socket body comprises
a first and second body portion, the first body portion defining the first plane surface and the second body portion defining the second plane surface, the first and second body portions being connected to each other such that they are movable relative to each other in a direction normal to the first and second plane surfaces, and
socket body pre-biasing means for biasing the first body portion against the second body portion normal to the first and second plane surfaces and, herewith, to provide additional spring stroke to the stroke provided by the individual spring-loaded test contact supports are provided.

2. Contactor socket of claim 1, wherein the first and second body portions are each plate-shaped and have main surfaces which are all parallel to each other, wherein the outermost main surfaces are the first and second plane surface.

3. Contactor socket of claim 1 or 2, wherein the socket body pre-biasing means are adapted for movably connecting the first and second body portions to each other and guiding them for a relative motion normal to the first and second plane surfaces.

4. Contactor socket of claim 3, wherein the socket body pre-biasing means comprise an elastomer sheet which is fixedly arranged, in particular glued, between the adjacent main surfaces of the first and second body portions.

5. Contactor socket of claim 1 or 2, wherein the socket body pre-biasing means comprise separate elastic members which are loosely inserted between the first and second body portions, and separate connecting and guiding means for connecting the first and second body portions and for guiding them for a motion normal to the first and second plane surfaces are provided.

6. Test socket of one of claims 1-3 or 5, wherein the socket body pre-biasing means comprise at least one pressure spring element arranged between the first and second body portions.

7. Contactor socket of claim 6, wherein the socket body pre-biasing means comprise at least two pressure spring elements arranged close to the short edges or the corners, respectively, of the first and second plane surfaces of the contactor socket body.

8. Contactor socket of claim 6 or 7, wherein the or each pressure spring element comprises a helical metal spring, in particular made of a copper-beryllium alloy or of steel.

9. Contactor socket of one of claims 1-3, wherein the socket body pre-biasing means comprise a pneumatic or hydraulic actuator, wherein in particular the biasing force of the pneumatic or hydraulic actuator is adjustable.

10. Contactor socket of one of the preceding claims, wherein the test contacts are probe pins and wherein the individual spring-loaded supports each comprise a helical metal spring.

11. Contactor socket of one of claims 1-9, wherein the test contacts are cantilever spring contacts and the individual spring-loaded supports thereof each comprise a cantilever spring.

12. Contactor socket of one of claims 6-11, wherein the pressure spring elements of the socket body pre-biasing means each have a stroke in the range between 0,1 and 1mm, preferably between 0,3 and 0,7mm, and/or a spring rate in the range between 1N and 10N, and optionally helical metal springs or cantilever springs of the test contacts have a stroke in the range between 0,02mm and 0,5mm, preferably between 0,03mm and 0,2mm, and/or a spring rate in the range between 0,02N and 0,2N, preferably between 0,05N and 0,10N.

13. Contactor socket of one of the preceding claims, comprising a gas inlet for introducing pressurized gas between the first and second body portions, and/or temperature control means adapted for controlling the temperature of at least one of the first and second body portions.

14. IC test handler comprising a contactor socket of one of the preceding claims.

15. IC test handler of claim 14, comprising a contactor socket of claim 13 and a pressurized gas supply for supplying pressurized gas to the contactor socket, and/or a temperature control unit for variably controlling the temperature of at least one of the first and second body portions of the contactor socket.
